Europäisches Patentamt

European Patent Office

Office européen des brevets

(11) Publication number: **0 402 966**

**A2**

# EUROPEAN PATENT APPLICATION

(21) Application number: 90201118.8

(51) Int. Cl.5: **H05K 3/46, H05K 3/38**

(22) Date of filing: **03.05.90**

(30) Priority: **15.06.89 JP 152702/89**

(43) Date of publication of application:
**19.12.90 Bulletin 90/51**

(84) Designated Contracting States:
**DE GB IT**

(71) Applicant: **MATSUSHITA ELECTRIC WORKS, LTD.**
**1048, Oaza-kadoma**
**Kadoma-shi Osaka 571(JP)**

(72) Inventor: **Awano, Tomio, c/o Matsushita Electric Works, Ltd.**
**1048, Oaza-Kadoma, Kadoma-shi**
**Osaka 571(JP)**
Inventor: **Akamatsu, Motoyuki, c/o Matsushita Electric Works**
**Ltd., 1048, Oaza-Kadoma, Kadoma-shi**
**Osaka 571(JP)**
Inventor: **Yamane, Tomoaki, c/o Matsushita**

**Electric Works**
**Ltd., 1048, Oaza-Kadoma, Kadoma-shi**
**Osaka 571(JP)**
Inventor: **Ichiki, Tsutomu, c/o Matsushita Electric Works**
**Ltd., 1048, Oaza-Kadoma, Kadoma-shi**
**Osaka 571(JP)**
Inventor: **Funo, Hideo, c/o Matsushita Electric Works**
**Ltd., 1048, Oaza-Kadoma, Kadoma-shi**
**Osaka 571(JP)**
Inventor: **Sagara, Takashi, c/o Matsushita Electric Works**
**Ltd., 1048, Oaza-Kadoma, Kadoma-shi**
**Osaka 571(JP)**

(74) Representative: **Kupecz, Arpad et al**
**Octrooibureau Los en Stigter B.V. Postbox 20052**
**NL-1000 HB Amsterdam(NL)**

(54) **Method for treating copper circuit pattern of interlayer circuit board.**

(57) A method for processing copper circuit pattern of interlayer circuit board carries out a reduction treatment with respect to the copper circuit pattern by causing a reducing gas to act on a surface of an oxide of copper formed on the copper circuit pattern for its surface roughening. A strong reducing action is thereby provided to the roughened surface of the oxide of copper and, consequently, the interlayer circuit board having the copper circuit pattern in which the oxide of copper mainly comprising cupric oxide is varied to cuprous oxide or a metallic copper can be obtained.

## Method for Treating Copper Circuit Pattern of Interlayer Circuit Board

### BACKGROUND OF THE INVENTION

This invention relates to a method for treating copper circuit pattern of interlayer circuit board.

The interlayer circuit board of the kind referred to is effectively utilized for manufacturing multilayer printed wiring board.

### DESCRIPTION OF RELATED ART

Generally, the multilayer printed wiring board of the kind referred to is manufactured by laminating prepregs and the interlayer circuit boards each having on one surface or both surfaces a circuit pattern formed by copper foil or the like, further laminating outerlayer circuit boards or copper foils, and subjecting resultant laminate to a hot pressure molding so as to make the interlayer circuit boards and outerlayer circuit boards or copper foils into an integral body.

In the multilayer printed wiring board, it is necessary to secure mutual adhesion between the copper circuit pattern on the interlayer circuit boards and a resin forming the prepregs used for laminating the outerlayer circuit boards. When in particular the circuit pattern of the interlayer circuit board is formed by an electrolytic copper foil, such copper foil will be rough on one surface but smooth on the other surface. In this event, there has been a drawback that the adhesion between the copper circuit pattern and the prepreg resin cannot be secured sufficiently in manufacturing the interlayer circuit board due to that the copper foil is adhered on the side of the rough surface to a base sheet member of the board so that the other smooth surface of the copper foil will have to be exposed as disposed on front side of the interlayer circuit board, so long as the copper foil is employed as it is.

There have been made various attempts to the effect of elevating the adhesion between the copper circuit pattern and the prepreg resin. For example, a measure has been taken for elevating the adhesion of the resin of the prepreg by forming an oxide of copper on the front surface of the copper circuit pattern. With this measure, the smooth surface of the copper circuit pattern is provided, through its oxidizing treatment, with very fine projections standing close to each other in microscopic view, so as to be roughened to thereby improve the adhesion of the copper circuit pattern with respect to the prepreg resin. As concrete method for forming the oxide of copper on the surface of the copper circuit pattern, there may be enumerated a solution treatment with, for examples an alkaline aqueous solution containing potassium persulfate or sodium chlorite.

However, the foregoing oxide of copper, in particular, cupric oxide is easily soluble to acid. When the multilayer printed wiring board including the interlayer circuit boards having such oxide of copper is subjected to a drilling for making through holes and thereafter to a dipping in a chemical plating bath or electroplating bath for providing a through hole plating, layers of the oxide of copper in the drilled copper circuit pattern exposed at peripheral surface of the through holes are caused to dissolve into such acid as hydrochloric acid or the like in the plating bath. Due to this, there arises such problem that an infiltration of acid between boundary surfaces of the copper circuit pattern and the prepreg resin takes place from the peripheral surface of the through holes so that a dissolution erosion will take place to render a so-called haloing phenomenon to be likely to occur, and the multilayer printed wiring board is made less reliable.

In order to overcome this problem, there has been suggested in Japanese Patent Application Laid-Open Publication No. 56-153797 by H. Iwasaki et al a measure for reducing the haloing phenomenon by immersing the interlayer circuit board having the oxide of copper on the surface of the copper circuit pattern into an alkaline reducer solution to reduce the oxide of copper into cuprous oxide or metallic copper which is hard to solve into acid while keeping very fine uneven state of the surface, so as to eliminate the haloing phenomenon. With the alkaline reducer solution employed in this measure, however, there still remains a problem that the reduction of the oxide of copper is unable to be so realized as to restrain the haloing phenomenon to a sufficiently satisfactory extent. On the other hand, there has been suggested another measure in U.S. Patent No. 4,642,161 by H. Akahoshi et al, in which an aqueous solution of amine boranes is used for the reduction of the oxide of copper formed on the surface of the copper circuit pattern. With this measure, the oxide of copper may be strongly reduced by the aqueous solution of amine boranes so as to effectively restrain the haloing phenomenon. In this case of the reduction with amine boranes employed therefor, however, reducing reaction is to be carried out in a sort of chain reaction with a certain portion as a core, so that there arises a problem that required reaction time involves a remarkable fluctuation since the reaction time varies depending the configuration of the copper circuit pattern so as not to allow a mass-production line to be smoothly arranged, in addition to that amine boranes are very expensive and less adaptable to practical use.

## SUMMARY OF THE INVENTION

A primary object of the present invention is, therefore, to provide a method for treating copper circuit pattern of interlayer circuit board, which method is capable of providing a strong reduction treatment to the oxide of copper formed for surface roughening with respect to the copper circuit pattern of the interlayer circuit board, so as to effectively restrain any haloing phenomenon and to increase the adhesion between the copper circuit pattern and the resin of prepregs, and of shortening and stabilizing the required reducing reaction time so as to render the mass producibility to be high and to be eventually contributive to a sufficient reduction of manufacturing costs.

According to the present invention, the above object can be attained by means of a method for treating copper circuit pattern of interlayer circuit board wherein the copper circuit pattern provided onto the interlayer circuit board is subjected to an oxidation to form an oxide of copper on the surface of the copper circuit pattern, and thereafter a reduction is carried out with respect to the surface of the oxide of copper for reducing the same, characterized in that the reduction is carried out by causing a reducing gas to act on the surface of the oxide of copper.

Other objects and advantages of the present invention will be clear from following description of the invention detailed with reference to certain examples of the method in respect of a laminate shown in accompanying drawing.

## BRIEF EXPLANATION OF DRAWING

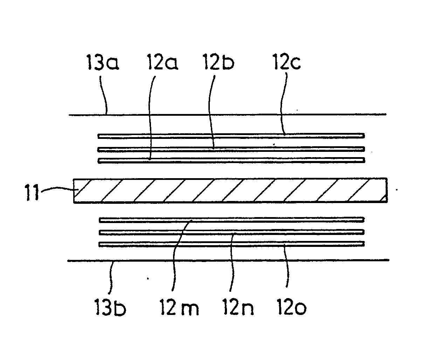

The drawing is an explanatory view for laminating steps for forming a multilayer printed wiring board with an interlayer circuit board obtained through the method for treating copper circuit pattern of the interlayer circuit board according to the present invention.

While the present invention shall now be described with reference to the various embodiments, it should be appreciated that the intention is not to limit the invention only to the embodiments described but rather to include all modifications, alterations and equivalent arrangements possible within the scope of appended claims.

## DETAILED DESCRIPTION OF THE PREFERRED EMBODIMENTS

For the interlayer circuit board employed in the present invention, it may be possible to employ a copper-clad glass epoxy laminate with a copper foil adhered, or a copper-clad glass polyimide laminate having on one surface or both a copper circuit pattern with the copper foil subjected to an etching process or the like. Further, it may be also possible to utilize a laminate having the copper circuit pattern formed on one surface or both through a chemical plating or an electroplating.

The interlayer circuit board should preferably be initially treated for a surface roughening, which can be realized by means of a buffing, treatment with chemicals through a soft etching or the like, electrolytic treatment, liquid honing or the like. In an event where a copper foil which has been preliminarily roughened on both surfaces is employed in the interlayer circuit board, the surface roughening treatment may be omitted.

Next, surfaces of the copper circuit pattern on the interlayer circuit board are subjected to an oxidation treatment which can be realized by treating the surfaces with an alkaline aqueous solution containing such an oxidizing agent as potassium persulfate, sodium chlorite or the like. With such oxidation treatment carried out, it is possible to form on the surfaces of the copper circuit pattern an oxide of copper, which oxide consists mainly of cupric oxide (CuO). Through this oxidation treatment, the oxide of copper is

3

produced in the form of very fine projections on the surfaces of the copper circuit pattern, so that the surfaces can be undulated and eventually roughened. After this formation of the oxide of copper on the surfaces of the copper circuit on the interlayer circuit board, a reducing gas is caused to act on the oxide of copper to have it reduced to cuprous oxide ($Cu_2O$) or metallic copper in a state in which the undulation remains on the surfaces of the copper circuit pattern. For the reducing gas, hydrogen is most preferable, while carbon monoxide (CO), ammonia ($NH_3$) or the like may also be employed, as other reducing gas than hydrogen. In reducing the oxide of copper with carbon monoxide or ammonia, however, it is necessary to carry out the reduction under a condition of being heated at such high temperature as to be above 300°C and, in order to carry out it at a lower temperature, it is required to employ such catalyst as platinum or the like or to atomize the reducing gas by means of an irradiation of ultraviolet ray or plasma. It is consequently most preferable in the utility to employ hydrogen which can attain the reduction at room temperatures and without requiring the gas atomization.

In the present invention, further, such a measure as detailed in the followings may be effectively employed to have the reducing gas acted on the oxide of copper. That is, the surface of the oxide layer on the copper circuit is initially coated with a metal which can be more easily ionized than the oxide of copper (mainly CuO). For the metal easier to be ionized, such metals of a standard electrode potential below +0.3V as Sn (-0.14V), Fe (-0.74V), Zn (-0.76V) and Al (-1.66V) may be enumerated, any of which metals may be employed alone or in a mixture of two or more. Further, these metals may be employed in powdery state, so that, for example, the surfaces of the copper circuit pattern are wetted with water and the surfaces of the oxide layer of the copper circuit pattern is coated by the metal powder. This coating of the oxide layer surface with the metal powder may be also realized by such other measures as an application onto the copper circuit pattern surfaces with a liquid made by dispersing the metal powder in water, solvent or the like, an immersing of the interlayer circuit board into such liquid as above, and so on. In this event, it is important that, irrespective of which coating measure is adopted, the oxide layer surface of the copper circuit pattern is coated with the metal, and the oxide of copper can be reduced through such reducing step as will be detailed later even when coating metal amount is uneven.

While the coating metal amount is not particularly limited, it may be made in a range of 1 to 300g/m$^2$, preferably about 5 to 100g/m$^2$, as an amount of being deposited on the surfaces of the oxide of copper on the copper circuit pattern. When the coating metal amount is less than 1g/m$^2$, the action of reducing the oxide of copper cannot be sufficiently obtained, while the coating metal amount exceeding 300g/m$^2$ renders dissolution amount of the metal into a treating liquid to be excessive at a step of dissolving the metal as will be detailed later and thus the treating liquid to be remarkably deteriorated, undesirably. While the coating metal employed in its powdery state is also not particularly limited in its particle diameter, it is preferable that the powder will be in a range of about 0.1 to 100μm in the average particle diameter. When the metal powder is smaller than 0.1μm in the average particle diameter, the powdery metal becomes larger in the specific surface area to be extremely easier to be oxidized, whereby there is caused a risk that the metal is oxidized during its preservation or during the treatment so as not to be able to show any reducing action any more. At the same time, the powder becomes likely to agglomerate and is uneasy to be handled. When on the other hand the average particle diameter of the metal powder is larger than 100μm, it becomes difficult to have the metal powder stably deposited on the surfaces of the copper circuit pattern since, particularly in the event where the metal powder is used as dispersed into water or any solvent, the metal powder easily settles out to render an even dispersion can hardly be maintained any more, and the stable deposition of the metal powder is made more difficult.

In order to improve the deposition stability of the metal powder onto the copper circuit pattern, it is desirable that a compound of the same metal is formed on the surface of the metal powder. That is, in the event when zinc powder is used, for example, it is preferable to employ the zinc powder having at its surface a layer of any of zinc oxide (ZnO), zinc carbonate ($ZnCO_3$), zinc chloride ($ZnCl_2$) and zinc hydroxide ($Zn(OH)_2$). While pure metals in their powdery state are generally of smooth surface to be low in the adhesion, the surface of the metal powder is made to have projections or to be higher in the adherence by the provision of the metal compound, so that the adhesion of the metal powder with respect to the copper circuit pattern surfaces can be increased. In this example of using the zinc powder as the metal powder, it is preferable to employ the one the surface of which is oxidized so that the composition of the Zn powder will be, in weight ratio, ZnO/(Zn + ZnO) = 0.03 to 0.90, and the oxidized surface of the Zn powder will have projections of a height more than 0.1μm (or more than 1/50 of particle diameter). It is easily possible to thus form the oxide on the surface of the metal powder, by dispersing the metal powder within water and heating them. Further, chloride, carbonate and hydroxide can be easily formed on the surface of the metal power with an addition of HCl, $Na_2CO_3$ or the like by an amount of 1 to 100ppm.

Im employing such a liquid as water or a solvent in which the metal powder is dispersed for the surface coating of the copper circuit pattern with the metal powder, it is normally difficult to have the metal powder uniformly dispersed in water or solvent, and it is desirable to have a substance contained in the liquid, the substance being effective to restrain the agglomeration of the metal powder and thus to render the dispersion excellent. As the substance for the agglomeration restraining, an inorganic fine powder of an average particle diameter less than 1μm and high in the bulk density, for example, fine powder of silicon dioxide ($SiO_2$), alumina ($Al_2O_3$) or the like may be employed. Further, a gelatinizer which increases the viscosity of the liquid may also be employed. As the gelatinizer, it is possible to use gelatin, starch, agar-agar, polyvinyl alcohol or the like. Further, a water soluble organic solvent may also be employed as the agglomeration restraining substance, which organic solvent may be one of ethylene glycol or butyl alcohol, polyethylene glycol, glycerine, any other alcohol and a lower fatty acid, and the organic solvent alone may be used instead of water. In this way, the metal powder is uniformly dispersed within the liquid in the state where the agglomeration restraining substance is contained, so that the metal powder can be uniformly deposited on the surfaces of the copper circuit pattern on the interlayer circuit board for the coating of them with the metal powder, by means of the application through a spraying, roll coating or the like of the uniform dispersion liquid of the metal powder, that is, by effectively utilizing the uniform dispersion liquid of the metal powder. In this case, the dispersion amount in the liquid of the metal powder should be properly in a range of about 1 to 2,000g per 1 liter.

After providing as in the above the metal coating on the surface of the oxide layer of the copper circuit pattern, the metal of the coating is caused to dissolve from the surface of the oxide layer by means of an acid. While not particularly limited, it is preferable to use, as the acid for solving the metal, such water soluble acid as sulfuric acid, hydrochloric acid or the like which is low in the oxidative effect. The dissolution of the metal by the acid can be attained by immersing the interlayer circuit board in a bath of an aqueous solution of the acid, or by spraying the aqueous solution of the acid against the interlayer circuit board. In the case when the metal is dissolved in the acid, the metal is more easily ionized than the oxide of copper and is dissolved in the state of cation with priority over the oxide of copper. Upon the dissolution of the metal by the acid, hydrogen is generated to cause a reducing action to take place on the oxide of copper on the surface of the copper circuit pattern, whereby cupric oxide (CuO) in the oxide of copper can be reduced to cuprous oxide ($Cu_2O$) or metallic copper (Cu). Since hydrogen in nascent state upon the dissolution of the metal in the aqueous solution of acid is in a state of an extremely high reactivity, the reducing action of hydrogen in nascent state will be so high that, in addition to that the particular hydrogen acts directly on the oxide of copper, the reduction of the oxide of copper can be strongly proceeded. By reducing in this way the oxide of copper formed on the surface of the copper circuit pattern, the oxide of copper can be made less dissolvable to acid, and the haloing occurring upon the dissolution by the acid can be effectively restrained.

While there may be a risk in this case that the undulation of the roughened surface due to the oxidation of copper is lost in an event where the oxide of copper on the surface of the copper circuit pattern is directely subjected to the dissolution by the acid, the coating of metal to be dissolved to the acid with priority over the oxide of copper as formed on the surface of the copper circuit pattern according to the present invention is effective to cause the oxide of copper to be reduced while being protected by the metal coating, whereby the oxide of copper on the copper circuit pattern surface can be reduced in the state of less dissolvable to acid while the surface undulation of the copper circuit pattern roughened upon oxidation of the copper foil is maintained by the metal coating. Further, the copper circuit pattern surfaces are wrapped by such gas as hydrogen generated upon the dissolution of the coating metal to the acid, so that the oxide of copper can be also protected by the gas from the acid. In dissolving the coating metal on the surface of the oxide of copper for the reduction of the oxide, it may be also possible to employ a strong alkaline aqueous solution of such alkali as sodium hydroxide or the like.

After the reducing treatment carried out as in the above with respect to the layer of the oxide of copper on the copper circuit pattern, a rinsing of the pattern with water or hot water or the like is immediately carried out and, after being dried, the thus treated interlayer circuit board is then processed through known steps for manufacturing the multilayer printed wiring board. More concretely, outerlayer circuit boards or other interlayer circuit boards, or copper foils, are stacked on the treated interlayer circuit board or boards through prepregs, thus obtained stack is hot-pressed to be molded into an integral multilayer body with the prepregs made as bonding layers therein, through-holes are then made in the molded body by means of a drilling work, a through-hole plating is provided by means of a chemical plating, outerlayer circuits are formed on the body through an etching or the like treatment, and the multilayer printed wiring board is thereby manufactured.

According to the foregoing measure for treating the copper circuit pattern of the interlayer circuit board of the present invention, an extremely effective reduction treatment can be carried out with respect to the oxide of copper which forming the uneven roughened surface of the copper circuit pattern, any haloing can be thereby reliably prevented from occurring, and the adhesion between the copper circuit pattern and the resin forming the prepregs and any others can be retained at a high level. Further, the coating of the metal powder over the oxide layer of copper on the copper circuit pattern allows the reduction treatment carried out without any risk of the dissolution of the oxide of copper, so that required treating time can be optimumly shortened, the mass producibility can be thereby improved, and the manufacturing costs can be eventual)y effectively reduced.

EXAMPLE 1:

AI) An interlayer circuit board was prepared with a glass-cloth base epoxy-resin laminate of 1.0mm thick and having on both surfaces copper foils 70$\mu$m thick (a product "R1766" by the present assignee firm) employed, and surfaces of the copper circuit pattern of this interlayer circuit board were treated to be roughened by means of buffing.

BI) A potassium persulfate bath was prepared as an oxidizing treatment bath with a composition of 13g/l of $K_2S_2O_8$ and 15g/l of NaOH and regulated to be at 60°C, and the above interlayer circuit board was immersed in this oxidizing treatment bath for 3 minutes to have the copper circuit pattern surfaces oxidized.

CI) The interlayer circuit board was then rinsed with water, a metallic Zn powder 6$\mu$m in the average particle diameter (a reagent class 1, product of Japanese firm JUNSEI KAGAKU K.K.) was applied as sprayed onto the surfaces of the interlayer circuit board, the surfaces being in a state of being kept slightly wetted, and the copper circuit pattern surfaces were coated with the Zn powder at a coating amount of about 50g/m$^2$.

DI) After providing the Zn powder coating, the interlayer circuit board was immersed in an aqueous solution of hydrochloric acid at its concentration of 10%, to have the Zn powder coating dissolved and removed, upon which the layer of the oxide of copper on the copper circuit pattern was subjected to a reducing action.

EI) Immediately after the dissolving of the Zn powder coating, the interlayer circuit board was rinsed with running water and was then dried.

FI) With respect to the thus treated interlayer circuit board II, as shown in the drawing, 3 sheets of prepregs 12a, 12b and 12c or 12m, 12n and 12o respectively of a thickness of 0.1mm and prepared by having a glass cloth base impregnated with an epoxy resin and drying the resin (a product "R1661" by the present assignee firm) were stacked on each of both surfaced of the board 11, copper foils 13a and 13b of a thickness of 18$\mu$m were further stacked on outermost surfaces to be built up into a laminate, and a multilayer printed wiring board was obtained by carrying out a secondary lamination molding of the laminate within an atmosphere of a pressure reduced to 6.7x10$^2$Pa. and under conditions of 170°C, 40kgf/cm$^2$ and 120 minutes.

EXAMPLE 2:

Except that the Zn powder coating amount onto the surfaces of the copper circuit pattern at foregoing CI step in the above Example 1 was made about 5g/m$^2$, a multilayer printed wiring board was obtained in the same manner as in Example 1.

EXAMPLE 3:

Except that the Zn powder coating amount onto the copper circuit pattern at the CI step in Example 1 was made to be about 250g/m$^2$, and that the immersing time of the interlayer circuit board into the 10% aqueous solution of hydrochloric acid at foregoing step DI in Example 1 was set to be 60 seconds, a multilayer printed wiring board was obtained in the same manner as in Example 1.

EXAMPLE 4:

Except that the Zn powder coating amount onto the copper circuit pattern at the CI step in Example 1 was made to be about 250g/m$^2$, that the immersing time of the interlayer circuit board into the 10% aqueous solution of hydrochloric acid at the step DI was set to be 120sec. for the reducing treatment of the oxide of copper, and that the interlayer circuit board was immersed again for further 60sec. in a separately prepared 10% aqueous solution of hydrochloric acid for removing still remained Zn on the cupper circuit pattern without being dissolved during the foregoing reducing treatment, a multilayer printed wiring board was obtained in the same manner as in Example 1.

EXAMPLE 5:

AII) The same interlayer circuit board as that prepared in Example 1 was subjected to a treatment for 1.5 minutes with a soft etching liquid of copper chloride prepared at a composition of 30g/l of $CuCl_2$ and 350ml of HCl and regulated at 30°C, to have the copper circuit pattern surfaces roughened.

BII) The interlayer circuit board was then immersed for 2 minutes in an oxidizing bath of sodium charbonate chlorite of a composition of 60g/l of $NaClO_2$, 10g/l of NaOH and 12g/l of $Na_3PO_4$ the bath being regulated to be at 95°C, to have the copper circuit pattern surfaces oxidized.

CII) The interlayer circuit board was then rinsed and was immersed for 5 minutes within a liquid made by dispersing into 1 lit. of water 500g of metal Sn powder of 10$\mu$m in the average particle diameter (a reagent class 1 by JUNSEI KAGAKU), to have the copper circuit pattern surfaces coated by the Sn powder, with a coating amount of about 60g/m$^2$.

DII) After the coating with Sn powder, the interlayer circuit board was immersed for 3 minutes in a 10% aqueous solution of hydrochloric acid, to have Sn dissolved and removed, upon which the oxide layer of copper on the copper circuit pattern was subjected to a reducing action.

EII) After the dissolving treatment, the interlayer circuit board was immediately rinsed with running water and was then dried.

FII) With the thus treated interlayer circuit board, a multilayer printed wiring board was obtained in the same manner as in the step FI in Example 1.

EXAMPLE 6:

The same interlayer circuit board as at the step AII of Example 5 was subjected to the same surface roughening and oxidizing treatments as at the steps AII and BII in Example 5, and was then further treated as follows:

CIII) The oxidized interlayer circuit board was then rinsed, and was thereafter immersed for 5 minutes in a liquid made by dispersing into 1 lit. of water 500g of metal Zn powder of 6$\mu$m in the average particle diameter and 500g of metal Sn powder of 10$\mu$m in the average particle diameter (both powder being reagents class 1 by JUNSEI KAGAKU), to have the copper circuit pattern surfaces coated with Zn powder and Sn powder, at a coating amount in total of about 100g/m$^2$.

With the thus coated interlayer circuit board, a multilayer printed wiring board was obtained through the same further steps as in Example 5.

EXAMPLE 7:

The interlayer circuit board surface-roughened and oxidized in the same manner as in the steps AII and BII of Example 5 was further treated through following steps:

CIV) The interlayer circuit board was immersed for 2 minutes in a liquid prepared by dispersing into 1 lit. of water 10g of metal Zn powder having an average particle diameter of 3$\mu$m and heating the liquid at 95°C for 10 minutes while agitating it to have the surface of Zn powder oxidized, the immersing having been made at 80°C while agitating, to have the copper circuit pattern surfaces coated with Zn powder, at a coating amount of about 10g/m$^2$.

DIV) After the coating with Zn powder, the interlayer circuit board was immersed for 2 minutes in a 20% aqueous solution of sulfuric acid, to have Zn dissolved and removed, upon which the oxide layer of copper on the copper circuit patten was subjected to a reducing action.

EIV) After the dissolving treatment, the interlayer circuit board was immediately rinsed with running water, and was then dried.

FIV) With the thus treated interlayer circuit board, a multilayer printed wiring board was obtained in the same manner as in the step FI in Example 1.

EXAMPLE 8:

The interlayer circuit board surface-roughened and oxidized in the same manner as in the steps AII and BII of Example 5 was further treated as follows:

CV) The interlayer circuit board was immersed for 2 minutes in a liquid prepared by dispersing in 1 lit. of water 100g of metal Zn powder 3$\mu$m in the average particle diameter (a product "LS-2" by a Japanese firm MITSUI KINZOKU TORYO KAGAKU K.K.), adding thereto 10mg of $Na_2CO_3$ and agitating for 30 minutes at 70°C so as to form zinc carbonate on the surface of Zn powder, the immersing having been carried out at 80°C while agitating, to have the copper circuit pattern surfaces coated with Zn powder at a coating amount of about 60g/m². With the thus treated interlayer circuit board, a multilayer printed wiring board was obtained in the same manner as in Example 5.

EXAMPLE 9:

Except that zinc chloride is formed on the surface of Zn powder by adding a 35% aqueous solution of hydrochloric acid instead of $Na_2CO_3$ added at the step CV in Example 8, a multilayer printed wiring board was obtained in the same manner as in Example 8.

EXAMPLE 10:

At the step CIII of Example 6, fine $SiO_2$ powder (a product #200 by a Japanese firm NIPPON AEROSIL KOGYO K.K.) was added to the liquid made by dispersing into water metal Zn powder and metal Sn powder so as to be 2% at weight ratio with respect to total amount of metal Zn and Sn powders, the liquid having been stirred at 1,000rpm for 30 minutes by means of a basket mill (a product "SS-3" by a Japanese firm ASADA TEKKO K.K.). Except for this respect, the interlayer circuit board similarly treated was employed and a multilayer printed wiring board was obtained in the same manner as in Example 6.

EXAMPLE 11:

A multilayer printed wiring board was obtained in the same manner as in Example 6, except for that 2g of starch was added to the immersing liquid with the metal Zn and Sn powders dispersed in water of 1 lit., the liquid having been heated at 60°C for 10 minutes.

EXAMPLE 12:

A multilayer printed wiring board was obtained in the same manner as in Example 6, except for a use of ethylene glycol instead of water in preparing the immersing liquid with metal Zn and Sn powders dispersed therein.

COMPARATIVE EXAMPLE 1:

A multilayer printed wiring board was obtained in the same manner as in Example 1, except that the coating with Zn powder and the treatment for dissolving the coated Zn powder with the aqueous solution of hydrochloric acid at the steps CI and DI were omitted.

COMPARATIVE EXAMPLE 2:

A multilayer printed wiring board was obtained in the same manner as in Example 6, except that the coating with Zn and Sn powders and their dissolving treatment with the aqueous solution of hydrochloric acid were omitted.

EP 0 402 966 A2

COMPARATIVE EXAMPLE 3:

A multilayer printed wiring board was obtained in the same manner as in Example 5, except that the interlayer circuit board surface-roughened and oxidized at the steps AII and BII in Example 5 was immersed for 5 minutes in an alkaline aqueous solution of reducing agent (in a composition of 2g/l NaBH$_4$ and 125g/l NaOH and 55°C) to have the oxide of copper on the copper circuit pattern reduced.

The respective multilayer printed wiring boards obtained through the above Examples 1-12 and Comparative Examples 1-3 were subjected to the through hole provision with a drill bit of 0.4mm in diameter, at a revolution of 80,000rpm and at a feed rate of 1.6m/min. Thus drilled boards were immersed for 60 minutes in a 17.5% aqueous solution of hydrochloric acid, and were observed through a microscope of 100 magnifications in respect of occurring state of haloing. Dimensions of the haloing observed in the respective boards (as measured as infiltration width of the hydrochloric acid solution from peripheral surface of the through holes into the boards) were as shown in following TABLE I. Further, the respective multilayer printed wiring boards were cut into sample pieces of 10mm width by means of a diamond cutter, and their adhesion between the copper circuit pattern surfaces treated and the prepregs was measured with an autographic recording device AGS-500B by a Japanese firm SHIMADZ SEISAKUSHO K.K. employed. Another set of the sample pieces were treated for boiling absorption test through D-4/100 (as immersed for 4 hours in distilled water at 100°C) and thereafter the adhesion between the treated surface of the copper circuit pattern and the prepreg. The ratio of the adhesion measured after the boiling absorption treatment with respect to the adhesion measured prior to the treatment was also calculated as maintained ratio (%). Results of these measurement and calculation are also shown in TABLE I.

TABLE I

| | EXAMPLES | | | | | | | | | | | | COMPARATIVE EXAMPLES | | |
|---|---|---|---|---|---|---|---|---|---|---|---|---|---|---|---|
| | 1 | 2 | 3 | 4 | 5 | 6 | 7 | 8 | 9 | 10 | 11 | 12 | 1 | 2 | 3 |
| Dimensions of Haloing (μm): | | | | | | | | | | | | | | | |
| Largest: | 50 | 30 | 10 | 10 | 120 | 30 | 30 | 20 | 0 | 0 | 20 | 20 | 490 | 610 | 430 |
| Average: | 15 | 23 | 5 | 3 | 75 | 11 | 7 | 5 | 0 | 0 | 9 | 10 | 240 | 300 | 70 |
| Adhesion (kgf/ch): | | | | | | | | | | | | | | | |
| Before treatment: | 1.62 | 0.67 | 1.49 | 1.39 | 1.13 | 1.59 | 1.42 | 1.39 | 1.48 | 1.57 | 1.21 | 1.12 | 1.85 | 1.73 | 1.23 |
| After treatment: | 1.38 | 0.54 | 1.33 | 1.23 | 0.77 | 1.38 | 1.16 | 1.27 | 1.42 | 1.38 | 1.04 | 0.97 | 0.65 | 0.48 | 0.83 |
| Maintained ratio (%): | 85 | 81 | 89 | 88 | 68 | 87 | 82 | 91 | 96 | 88 | 86 | 87 | 35 | 28 | 67 |

As will be clear from the above TABLE I, it has been found that the multilayer printed wiring boards of Examples 1 through 12 according to the present invention in which the copper circuit pattern surface is once treated to have the oxide layer of copper, the oxide layer is coated with metal Zn or Sn powder and then the metal powder is dissolved by acid to be removed to have the oxide layer on the copper circuit pattern reduced are capable of restraining the haloing in contrast to the ones of Comparative Examples 1 and 2 in which no such treatment as in the present invention is carried out. It has been also found that the wiring boards of Examples 1 through 12 can remarkably reduce the haloing even in comparison with the one of Comparative Example 3 the reducing treatment of which has been made by the alkaline reducing agent. In respect of the adhesion between the copper circuit pattern and the prepreg, it has been further found that the wiring boards of Examples 1 through 12 according to the present invention are high in the maintained ratio of the adhesion, and even the boiling absorption treatment less reduces the adhesion.

According to another feature of the present invention, the reducing treatment is carried out in such that, after the formation of the oxide of copper on the copper circuit pattern of the interlayer circuit board, this circuit board is immersed in a treating liquid in which hydrogen is generated with addition of a metal of a standard electrode potential below +0.3V, i.e., a metal showing a more remarkable tendency of ionization than copper. As the treating liquid, in this case, water in which a powdery metal of the standard electrode potential below +0.3V is dispersed so as to cause hydrogen generated may be employed.

For the metal below +0.3V in the standard electrode potential, Sn (-0.14V), Fe (-0.74V), Zn (-0.76V) and the like may be enumerated, while such others as K, Na, Mg, Ni and the like will be also employable, which metals will be employable respectively alone or as a mixture of two or more. These metals are to be used in powdery state in order to promote the reducing reaction and to elevate contacting frequency with respect to the oxide of copper on the copper circuit pattern of the interlayer circuit board. The metal powder should preferably be of an average particle diameter less than $100\mu m$ in view of the specific surface area of the metal powder made larger, excellent hydrogen generating efficiency and less sedimentation in the treating liquid. In order to attain the reducing reaction sufficiently, the treating liquid is regulated by dispersing the metal powder in a concentration of more than 1g or preferably more than 10g per 1 lit. of water. When the metal powder of the standard electrode potention below +0.3V is dispersed in water, there arises a reaction between the metal powder and water.

For example, the reaction occurs in such that

$$3Fe + 8H_2O \longrightarrow Fe_3O_4 + 4H_2O + 8H^+$$

any hydrogen is generated. Since this reaction is accelerated as the temperature rises, the higher treating liquid temperature, the more preferable. When the interlayer circuit board is immersed in this treating liquid, the generated hydrogen acts on the oxide of copper formed on the copper circuit in such that

$$2CuO + 2H^+ \longrightarrow Cu_2O + H_2O$$
$$CuO + 2H^+ \longrightarrow Cu + H_2O$$

so that cupric oxide (CuO) within the oxide of copper can be reduced effectively as to be cuprous oxide ($Cu_2O$) or metallic copper, whereby, for the same reason as in the foregoing embodiment, the reactivity is made high, a strong reduction of the oxide of copper can be attained and an effective restrain of the haloing is attainable. In respect of this treating liquid, it is preferable to agitate or heat it for promoting the generation of hydrogen and, particularly when iron or zinc is used as the metal, it is desirable to heat the liquid to a state close to boiling.

Further in the present invention, other than the treating liquid of water with the metal powder of the standard electrode potential below +0.3V dispersed therein for the hydrogen generation, it is possible to employ another treating liquid of an acidic or alkaline solution with the metal of the standard electrode potential below +0.3V added for the hydrogen generation. For the metal of the standard electrode potential below +0.3V to be employed here, the same metals as those described in the above may be used but, for others, it is also possible to use an amalgam of Zn, Sn, Fe or the like. This metal should preferably be employed in the state of powder for the promotion of the reducing reaction and the elevation of the contacting frequency with respect to the oxide of copper on the copper circuit of the interlayer circuit board. As has been described, it is also preferable that the metal powder is of an average particle diameter less than $100\mu m$, and the treating liquid should desirably be regulated to be as high as possible in the concentration of the metal powder in order to attain a sufficient effect of the reducing reaction. When the metal of the standard electrode potential below +0.3V is added to such acidic or alkaline solution, the metal dissolves to the solution and hydrogen is generated. As the metal fully dissolves to the acidic or alkaline solution, the hydrogen generation should stop, and the metal powder should preferably be continuously added to and mixed with the acidic or alkaline solution so that hydrogen can be generated continuously. When the interlayer circuit board is immersed in this treating liquid, the generated hydrogen acts on the oxide of copper formed on the copper circuit pattern of the interlayer circuit board, and cupric oxide (CuO) in the oxide of copper can be reduced effectively into cuprous oxide ($Cu_2O$) or metallic copper (Cu). Particularly, hydrogen in the nascent state immediately after the generation of hydrogen due to the reaction of the metal to acid or alkali is extremely high in the reducing action so that the hydrogen in the nascent state can contact directly with the oxide of copper within the treating liquid to strongly reduce the oxide of copper. For the purpose of effectively achieving the reduction of the oxide of copper, on the other hand, it is desirable to use an acidic reducing agent as acid or alkali of the treating liquid. For the acidic reducing agent, it is preferable to employ such ones of an oxidation-reduction potential below +0.3V as formic acid (-0.2V), sulfamic acid (-0.2V) and hypophosphoric acid (-0.5V).

In causing the acid of alkali to act on the oxide of copper as in the above, there will arise a risk that the unevenly roughened surface formed by the oxidation of copper may disapper as the oxide of copper on the copper circuit pattern is dissolved by the acid or alkali. However, the metal of the standard electrode potential below +0.3V dissolves to the acid or alkali with priority over the oxide of copper, and the use of the acidic reducing agent as described in the above renders the speed of the reduction of the oxide of copper to become cuprous oxide or metallic copper which is hard to dissolve to acid to be remarkably higher than the speed of the dissolution, so that the oxide of copper can be reduced while being prevented from dissolving to acid or alkali and the oxide of copper can be effectively reduced into the state of being hard to dissolve to acid while maintaining the unevenly roughened surface of the oxide. Further, as in the foregoing embodiment, it is possible to use fine powder of such agglomeration restraining substance as $SiO_2$ or $Al_2O_3$ of an average particle diameter smaller than $1\mu m$ for restraining the agglomeration and, after the reduction of the layer of the oxide of copper, a rinsing and dissolution may be carried out for removing the metal powder with an aqueous solution of such acid as HCl, $H_2SO_4$ or the like or with an aqueous solution of such alkali as NaOH, KOH or the like. Further, it may be also possible to blow air with an air gun or water with a water jet against the interlayer circuit board to wash out the powder. Thereafter, the interlayer circuit board is rinsed with water or hot water or the like and is dried, and the multilayer printed wiring board can be manufactured therewith in the same manner in the foregoing embodiment.

In the present embodiment, the adhesion between the copper circuit pattern and the prepreg resin can be effectively improved similarly to the foregoing embodiment, required treating time can be shortened to improve the mass producibility, the hydrogen generation in particular with the addition of the metal below +0.3V in the standard electrode potential allows the haloing effectively restrained so as to attain the adhesion more remarkably made high.

EXAMPLE 13:

The surface roughening and oxidizing treatments of the copper circuit pattern of the interlayer circuit board were carried out in the same manner as in the steps AI and BI in Example 1.

CVI) A reduction treatment liquid was prepared by adding to an acidic reducing agent of hypophosphoric acid (a reagent class 1 of JUNSEI KAGAKU) dissolved by 3g to 1 lit. of water a metal Zn powder of an average particle diameter of about $6\mu m$ ("LS-5" by MITSUI KINZOKU TORYO KAGAKU) by 5g to 1 lit., the surface treated interlayer circuit board was immersed in this treating liquid and so maintained for 5 minutes at a room temperature while agitating the liquid with agitating vanes rotated at 600rpm, upon which the oxide of copper on the copper circuit pattern was subjected to the reducing action.

DVI) After the reducing treatment, the interlayer circuit board was rinsed with a water jet to remove the Zn powder deposited on the interlayer circuit board, further rinsed with hot water and then dried.

EVI) Since the metal powder was remained by about $2.5g/m^2$ after the water jet rinsing, the interlayer circuit board was immersed for 3 minutes in a 10% aqueous solution of $H_2SO_4$ to have the metal Zn powder removed completely, and thereafter the board was immediately rinsed with running water and was dried.

FVI) With the thus treated interlayer circuit board, a multilayer printed wiring board was obtained in the same manner as in Example 1.

EXAMPLE 14:

A multilayer printed wiring board was obtained in the same manner as in Example 13, except that 10g of sulfamic acid was dissolved instead of hypophosphoric acid at the step CVI, and that the added amount of the metal Zn powder was modified to 10g.

EXAMPLE 15:

A multilayer printed wiring board was obtained in the same manner as in Example 13, except that formic acid was employed instead of hypophosphoric acid in Example 13, 20g of formic acid being dissolved in 1 lit. of water so as to be the acidic bath, and that a metal Zn powder of about $6\mu m$ in the average particle diameter ("LS-5" by MITSUI KINZOKU TORYO KAGAKU) was added by 80g to 1 lit. of the acidic bath.

EXAMPLE 16:

The surface roughening and oxidizing treatments of the copper circuit pattern of the interlayer circuit board were carried out in the same manner as in the steps AI and BI of Example 1.

CVII) A reduction treatment liquid was prepared by adding to an acidic bath of hypophosphoric acid (the reagent class 1 by JUNSEI KAGAKU) dissolved by 20g with respect to 1 lit. of water a metal Sn powder of an average particle diameter of about $10\mu m$, and the surface treated interlayer circuit board was immersed in this treating liquid and so maintained for 5 minutes at a room temperature while agitating the liquid with agitating vanes rotated at 600rpm, upon which the oxide layer of copper on the copper circuit pattern was subjected to the reducing action.

DVII) After this reducing treatment, the interlayer circuit board was subjected to an air blow to remove the Zn powder deposited on the interlayer circuit board, and then the board was rinsed with hot water and dried.

EVII) Since the removal by means of the air blow only was insufficient and the Sn powder was kept remained by about $0.5g/m^2$, the interlayer circuit board was immersed for 3 minutes in a 10% aqueous solution of NaOH to completely remove the Sn powder, and thereafter the interlayer circuit board was immediately rinsed with running water and dried.

FVII) With the thus treated interlayer circuit board, a multilayer printed wiring board was obtained in the same manner as in Example 1.

## EXAMPLE 17:

The surface roughening and oxidizing treatments of the copper circuit pattern of the interlayer circuit board were carried out in the same manner as in the steps AI and BI of Example 1.

CVIII) A reduction treatment liquid was prepared by adding and dispersing to 1 lit. of water respectively 1,000g of a metal Zn powder about 6μm in the average particle diameter, a metal Sn powder about 10μm in the average particle diameter and a metal Fe powder about 15μm in the average particle diameter (respectively a reagent class 1 by JUNSEI KAGAKU), and the surface treated interlayer circuit board was immersed for 5 minutes in this treating liquid while heating it to 40°C and agitating with agitating vanes rotated at 600rpm, upon which the oxide layer of copper on the copper circuit pattern was subjected to a reducing action.

DVIII) After this reducing treatment, the interlayer circuit board was subjected to a water jet washing to remove the Zn powder, Sn powder and Fe powder deposited on the interlayer circuit board.

EVIII) Since the removal by means of the water jet only was insufficient for removing the metal powders and they were kept remained as deposited by about $1.5g/m^2$, the interlayer circuit board was immersed for 3 minutes in a 10% aqueous solution of $H_2SO_4$ to completely remove the Zn powder, Sn powder and Fe powder, and thereafter the interlayer circuit board was immediately rinsed with running water and dried.

FVIII) With the thus treated interlayer circuit board, a multilayer printed wiring board was obtained in the same manner as in Example 1.

## EXAMPLE 18:

A multilayer printed wiring board was obtained in the same manner as in Example 17, except for modification of the amount of addition of the respective metal Zn, Sn and Fe powders at the step CVIII in Example 17 to 20g and of the temperature of the reduction treatment liquid to 90°C.

## EXAMPLE 19:

The surface roughening and oxidizing treatments of the copper circuit pattern of the interlayer circuit board were carried out in the same manner as in the steps AII and BII of Example 5.

CIX) A reduction treatment liquid was prepared by adding to an acidic reducing agent of sulfamic acid (a reagent class 1 by JUNSEI KAGAKU) dissolved by 20g to 1 lit. of water the metal Zn powder about 7μm in the average particle diameter ("LS-5" of MITSUI KINZOKU TORYO KAGAKU) and metal Sn powder about 10μm in the average particle diameter (the reagent class 1 of JUNSEI KAGAKU) respectively by 200g with respect to 1 lit. of water, and the interlayer circuit board was immersed in this treatment liquid and so maintained for 5 minutes while agitating the liquid with agitating vanes rotated at 600rpm, upon which the oxide layer of copper on the copper circuit pattern was subjected to a reducing action.

A multilayer printed wiring board was obtained through the same steps as those DVI, EVI and FVI in Example 13.

## EXAMPLE 20:

A multilayer printed wiring board was obtained in the same manner as in Example 19, except that 2wt.% of fine $SiO_2$ powder (#200 of NIPPON AEROSIL) with respect to total amount of the metal Zn and Sn powders in the step CIX of Example 19 was added to water and they were agitated at 1,000rpm for 30 minutes with the basket mill ("SS-3" of ASADA TEKKO), prior to the dissolution of sulfamic acid.

COMPARATIVE EXAMPLE 4:

A multilayer printed wiring board was obtained in the same manner as in Example 13, except that the reduction and subsequent treatments at the steps CVI through EVI in Example were omitted.

COMPARATIVE EXAMPLE 5:

A multilayer printed wiring board was obtained in the same manner as in Example 19, except that the reduction and subsequent treatments of the step CIX were omitted.

COMPARATIVE EXAMPLE 6:

A multilayer printed wiring board was obtained with the interlayer circuit board surface roughened and oxidized at the steps AI and BI of Example 1 but subjected to a reduction treatment of the oxide of copper on the copper circuit pattern by immersing the board for 5 minutes in an alkaline aqueous solution of reducing agent (2g/l sodium borohydride and 125g/l NaOH at liquid temperature of 55°C), followed by the same subsequent steps as in Example 13.

COMPARATIVE EXAMPLE 7:

The reduction treatment in Examples 13 to 15 was carried out with the treating liquid but prepared by adding only hypophosphoric acid, sulfamic acid or formic acid and without addition of any metal powder, in which event the dissolution of the oxide of copper on the copper circuit pattern took place prior to the reduction and the board was no more utilizable in practice.

Dimensions of the haloing and the adhesion between the treated surface of the copper circuit pattern and the prepreg were measured with respect to the respective multilayer printed wiring boards of the above Examples 13 through 20 and Comparative Examples 4 through 6, in the same manner as in the measurement for the foregoing Examples 1 through 12 and Comparative Examples 1 through 3, and results of such measurement were as shown in following Table II:

TABLE II

| | EXAMPLES | | | | | | | | COMP. EXAMPLES | | |
|---|---|---|---|---|---|---|---|---|---|---|---|
| | 13 | 14 | 15 | 16 | 17 | 18 | 19 | 20 | 4 | 5 | 6 |
| Dim. of haloing ($\mu$m) | | | | | | | | | | | |
| Largest:<br>Average: | 140<br>73 | 110<br>61 | 30<br>15 | 240<br>130 | 20<br>7 | 50<br>33 | 40<br>21 | 30<br>13 | 490<br>240 | 610<br>300 | 430<br>70 |
| Adhesion (Kgf/cm) | | | | | | | | | | | |
| Before treat.<br>After treat.<br>Maint'd ratio(%) | 1.66<br>0.88<br>53 | 1.63<br>1.13<br>69 | 1.58<br>1.21<br>77 | 1.32<br>0.73<br>55 | 1.48<br>1.35<br>91 | 1.67<br>1.35<br>81 | 1.32<br>0.83<br>63 | 1.39<br>1.00<br>72 | 1.85<br>0.65<br>35 | 1.73<br>0.48<br>28 | 1.23<br>0.83<br>67 |

As will be clear from the above Table II, it has been found that the multilayer printed wiring boards of Examples 13 through 20 according to the present invention in which the oxide of copper on the copper circuit pattern was reduced by the immersion of the board, after the oxidizing treatment of the copper circuit pattern, into the treating liquid being made to generate hydrogen by the addition of Zn, Sn or Fe are effective to remarkably restrain the haloing quite in contrast to those not subjected to such treatment. In respect of the adhesion between the copper circuit pattern and the prepreg, too, it has been confirmed that the ones of Examples 13-20 according to the present invention are extremely high in the maintained ratio, and that any deterioration in the adhesion even after the boiling treatment is not remarkable.

**Claims**

1. A method for treating copper circuit pattern of interlayer circuit board wherein said copper circuit pattern provided onto said interlayer circuit board is subjected to an oxidation to form an oxide of copper on the surface of the copper circuit pattern, and thereafter a reduction is carried out with respect to the surface of hte oxide of copper for reducing the same, **characterized** in that the reduction is carried out by causing a reducing gas to act on the surface of the oxide of copper.

2. The method of claim 1 wherein said reducing gas is hydrogen in nascent state.

3. The method of claim 1 wherein said oxide of copper is provided over its surface with a coating of a metal easier to be ionized than the oxide of copper, and thereafter said reduction is carried out by dissolving said metal coating and generating said reducing gas.

4. The method of claim 3 wherein said metal easier to be ionized is one of the standard electrode potential below +0.3V.

5. The method of claim 3 wherein said metal easier to be ionized is at least one selected from the group consisting of Sn, Fe, Zn and Al.

6. The method of claim 3 wherein said metal easier to be ionized is in powdery state of an average particle diameter smaller than 100μm.

7. The method of claim 6 wherein said metal powder is one having a compound of said metal formed on the surface of particles of the metal.

8. The method of claim 3 wherein said metal coating provided by bringing said interlayer circuit board into contact with a liquid in which said metal in powdery state is dispersed.

9. The method of claim 8 wherein said liquid having therein said metal powder dispersed includes a substance which restrains agglomeration of the metal powder.

10. The method of claim 9 wherein said agglomeration restraining substance is a fine inorganic powder.

11. The method of claim 9 wherein said agglomeration restraining substance is a water soluble organic solvent.

12. The method of claim 9 wherein said agglomeration restraining substance is a gelatinizer.

13. The method of claim 3 wherein said metal coating over said oxide of copper is carried out in a range of 1 to 300g/m². 

14. The method of claim 1 wherein said reduction is carried out by bringing said interlayer circuit board into contact with a treating liquid in which hydrogen is being generated by an added metal of the standard electrode potential below +0.3V.

15. The method of claim 14 wherein said hydrogen is in nascent state.

16. The method of claim 14 wherein said added metal is in powdery state, and said treating liquid is of water in which said metal powder is dispersed.

17. The method of claim 14 wherein said treating liquid is of an acidic solution in which said added metal is dissolved.

18. The method of claim 14 wherein said treating liquid is of an alkaline solution in which said added metal is dissolved.

19. The method of claim 14 wherein said added metal is at least one selected from a group consisting of Sn, Fe and Zn.

20. The method of claim 14 wherein said added metal is in a powder of an average particle diameter below 100μm.

21. The method of claim 14 wherein said added metal is in a powder, and said treating liquid contains a substance which restrains agglomeration of said metal powder.

22. The method of claim 21 wherein said agglomeration restraining substance is of a fine inorganic powder.

23. The method of claim 14 wherein said added metal is in a powder, and said interlayer circuit board brought into contact with said treating liquid is rinsed with an acidic solution to remove said metal powder remained as deposited on the interlayer circuit board.

24. The method of claim 14 wherein said added metal is in a powder, and said interlayer circuit board brought into contact with said treating liquid is rinsed with an alkaline solution to remove said metal powder remained as deposited on the interlayer circuit board.

25. The method of claim 14 wherein said added metal is in a powder, and said interlayer circuit board brought into contact with said treating liquid is subjected at least to air blown thereagainst to remove said metal powder remained as deposited on the interlayer circuit board.

26. The method of claim 14 wherein said added metal is in a powder, and said interlayer circuit board brought into contact with said treating liquid is subjected at least to a liquid blown thereagainst to remove said metal powder remained as deposited on the interlayer circuit board.

27. The method of claim 17 wherein said treating liquid is of an acidic reducing agent.

28. The method of claim 18 wherein said treating liquid is of an acidic reducing agent.

29. The method of claim 27 wherein said acidic reducing agent is of an oxidation-reduction potential below +0.3V.

30. The method of claim 28 wherein said acidic reducing agent is of an oxidation-reduction potential below +0.3V.

31. The method of claim 29 wherein said acidic reducing agent is at least one selected from the group consisting of formic acid, sulfamic acid and hypophosphoric acid.

32. The method of claim 30 wherein said acidic reducing agent is at least one selected from the group consisting of formic acid, sulfamic acid and hypophosphoric acid.

13a     12a     12b     12c

11

13b     12m     12n     12o